(19) Europäisches Patentamt
European Patent Office
Office européen des brevets

(11) **EP 3 977 045 B1**

(12) **EUROPÄISCHE PATENTSCHRIFT**

(45) Veröffentlichungstag und Bekanntmachung des Hinweises auf die Patenterteilung:
**02.04.2025  Patentblatt 2025/14**

(21) Anmeldenummer: **20726288.2**

(22) Anmeldetag: **17.04.2020**

(51) Internationale Patentklassifikation (IPC):
**G01B 9/02** *(2022.01)*     **H01S 5/02** *(2006.01)*

(52) Gemeinsame Patentklassifikation (CPC):
**G01B 9/02007; G01B 9/02003; H01S 5/02476; H01S 5/423;** H01S 5/02415; H01S 5/04256; H01S 5/06804; H01S 5/4087

(86) Internationale Anmeldenummer:
**PCT/DE2020/100317**

(87) Internationale Veröffentlichungsnummer:
**WO 2020/239162 (03.12.2020 Gazette 2020/49)**

(54) **VORRICHTUNG ZUR ERZEUGUNG EINER SYNTHETISCHEN WELLENLÄNGE UND MESSVORRICHTUNG**

DEVICE FOR GENERATING A SYNTHETIC WAVELENGTH AND MEASURING DEVICE

DISPOSITIF DE PRODUCTION D'UNE LONGUEUR D'ONDE SYNTHÉTIQUE ET DISPOSITIF DE MESURE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität:  **28.05.2019   DE 102019114361**

(43) Veröffentlichungstag der Anmeldung:
**06.04.2022   Patentblatt 2022/14**

(73) Patentinhaber: **Stiftung für Lasertechnologien in der Medizin und Messtechnik an der Universität Ulm Ilm 89081 Ulm (DE)**

(72) Erfinder:
• **HILBST, Raimund 89155 Erbach (DE)**
• **CLAUS, Daniel 89257 Illertissen (DE)**

(74) Vertreter: **Konrad, Michael Patentanwalt Brühlhof 3 72072 Tübingen (Bühl) (DE)**

(56) Entgegenhaltungen:
US-A- 6 002 705

• YANG MEI ET AL: "A comparative study of thermal characteristics of GaN-based VCSELs with three different typical structures", SEMICONDUCTOR SCIENCE AND TECHNOLOGY, IOP PUBLISHING LTD, GB, vol. 33, no. 1, 12 December 2017 (2017-12-12), pages 15016, XP020322826, ISSN: 0268-1242, [retrieved on 20171212], DOI: 10.1088/1361-6641/AA90AA

**Beschreibung**

Die Erfindung betrifft eine Vorrichtung zur Erzeugung einer synthetischen Wellenlänge, insbesondere eine miniaturisierte kohärente Mehrwellenlängen-Lichtquelle zur Erzeugung von Licht, welche spektralstabile Strahlung emittiert und somit die Einstellung von synthetischen Wellenlängen für Mess- und Beobachtungssystemen ermöglicht. Die Erfindung betrifft darüber hinaus eine Messvorrichtung.

Interferometrische Verfahren sind in der Messtechnik seit langem etabliert. Sie zeichnen sich durch eine hohe Messgenauigkeit im nm-Bereich bei einem relativ kleinen Messbereich aus.

Zur Vergrößerung des Messbereichs können bei niedrigeren Anforderungen an die Auflösung anstatt der Wellenlänge des Lichts synthetische Wellenlängen genutzt werden. Diese entstehen durch kohärente Überlagerung von zwei Lichtwellen mit (leicht) unterschiedlichen Grundwellenlängen $\lambda_1$, $\lambda_2$. Die synthetische Wellenlänge $\Lambda_S$ ist gegeben durch

$$\Lambda_S = \frac{\lambda_1 \cdot \lambda_2}{|\lambda_1 - \lambda_2|} \qquad (1)$$

Damit die synthetische Wellenlänge für interferometrische Messungen und auch für andere quantitative Phasenmessungen genutzt werden kann, muss diese synthetische Wellenlänge zeitlich sehr stabil sein. Hierfür muss insbesondere die Differenz der Ausgangswellenlängen sehr konstant sein.

Nachteil der bekannten Vorrichtungen ist, dass ein großer technischer Aufwand betrieben werden muss, die Vorrichtungen entsprechend stabil betreiben zu können. So werden z.B. Lasersysteme verwendet, die einen beträchtlichen Kostenfaktor darstellen. Eine weitere Möglichkeit ist eine aktive Stabilisierung der Temperatur, wobei jedoch qualitativ hochwertige Temperatursensoren eingesetzt werden müssen, welche ebenfalls vergleichsweise teuer sind.

Die Erzeugung einer synthetischen Wellenlänge aus zwei einander ähnelnden Grundwellenlängen wurde bereits in der Literatur beschrieben (vgl. z.B. Wyant J C 1971 "Testing aspherics using two-wavelength holography" Appl. Opt. 10 2113-8). Mittlerweile hat sich die Nutzung synthetischer Wellenlängen etabliert. Beispielsweise beschreibt EP 2 589 923 A1 eine Vorrichtung zur Messung der Distanz zwischen einer Referenz- und einer Testoberfläche.

US 6 002 705 A beschreibt eine Vorrichtung mit vier Oberflächenemittern, , die auf einem GaAs Trägerelement positioniert sind.

Aufgabe der vorliegenden Erfindung war es, die Nachteile des Standes der Technik zu überwinden und eine Vorrichtung zur Verfügung zu stellen, mittels derer ein Benutzer in der Lage ist, auf einfache und kostengünstige Weise eine synthetische Wellenlänge zu erzeugen. Insbesondere war eine Aufgabe der Erfindung, eine (miniaturisierte) kohärente Mehrwellenlängen-Lichtquelle zur Erzeugung von zeitlich stabilisiert emittierten Wellenlängen bereitzustellen, welche eine stabile, und bevorzugt einstellbare, synthetischen Wellenlänge für Mess- und Beobachtungssysteme generiert. Eine weitere Aufgabe war die Bereitstellung einer verbesserten Messvorrichtung.

Diese Aufgabe wird durch eine Vorrichtung gemäß den Ansprüchen gelöst.

Die erfindungsgemäße Vorrichtung zur Erzeugung einer synthetischen Wellenlänge umfasst mindestens zwei Oberflächenemitter und ein Trägerelement, wobei das Trägerelement ein Wärmeleiter ist und beide Oberflächenemitter in, an oder auf dem Trägerelement fest angeordnet sind.

Ein Oberflächenemitter (auch als "VCSEL" bezeichnet von engl.: "Vertical-Cavity Surface-Emitting Laser) ist eine Laserdiode, bei der das Licht senkrecht zur Ebene des Halbleiterchips typischerweise im Milliwattbereich abgestrahlt wird. Damit unterscheidet sich ein Oberflächenemitter-Element von kantenemittierenden Laserdioden, bei denen das Licht an einer oder zwei Seitenflanken des Halbleiterchips austritt. Ein Oberflächenemitter im Sinne der Erfindung umfasst zumindest einen oberflächenemittierenden Halbleiterchip (der auch als der eigentliche Oberflächenemitter angesehen werden kann). Der Halbleiterchip kann in einem umgebenden Gehäuse angeordnet sein, kann aber auch als Halbleiterchip direkt auf, an oder in dem Trägerelement angeordnet sein. Die Oberflächenemitter sind z.B. Single-Mode vertikal emittierende Laserdioden.

Solche Single-mode VCSEL (z.B. longitudinal monomodig) sind beispielsweise mit bestimmungsgemäßen Grundwellenlängen von 795 nm, 852 nm, 895 nm und 940 nm als Standardprodukte auf dem Markt erhältlich. VCSEL haben die für die Erfindung günstigen Eigenschaften, dass ihre Bandbreite mit $\Delta\lambda < 2$ pm ausreichend gering ist und ihre Kohärenzlänge mit etwa 50 cm vergleichsweise groß und für die Interferometrie besonders günstig ist.

Als Trägerelement wird ein Bauteil verstanden, welches als Wärmebrücke zwischen den Oberflächenemittern dient, diese also über das Trägerelement miteinander in thermischen Kontakt stehen. Dazu muss das Trägerelement ein Wärmeleiter sein. Zwar ist jedes Material im Grunde wärmeleitend, jedoch werden nur Materialien mit einer vergleichsweise großen Wärmeleitfähigkeit > 2 W/(m·K) als Wärmeleiter im Sinne der Erfindung angesehen. Thermische Isolatoren oder Materialien mit einem kleinen Wärmeleitkoeffizienten sind keine Wärmeleiter im Rahmen dieser Erfindung. Bevorzugt ist das Trägerelement im Wesentlichen aus Materialien gefertigt, deren Wärmeleitfähigkeit zumindest größer als 40 W/(m·K) ist, insbesondere größer als 200 W/(m·K) oder 270 W/(m·K), besonders bevorzugt größer als 300 W/(m·K). Bevorzugte Materialien sind Metalle, insbesondere Aluminium oder Kupfer, oder Kohlenstoffverbindungen. "Im Wesentlichen" bedeutet hier, dass durchaus andere Materialien (auch keine Wärmeleiter) enthalten sein dürfen, z.B. Isolatormaterialien zur Trennung von Leiterbahnen von anderen leitenden Bereichen, sofern zumindest diese Materialien den Wärmefluss zwischen den Oberflächenemittern nicht wesentlich behindern, z.B. dünn ausgestaltet sind. Bevorzugt bedeutet "im Wesentlichen", dass das Trägerelement zu mindestens 90% ein vorgenanntes wärmeleitendes Material umfasst.

Ein bevorzugtes Material für das Trägerelement ist Aluminiumnitrid. Dieses hat typischerweise eine Wärmeleitfähigkeit von 285 W/(m·K) und ist besonders vorteilhaft, da dessen thermischer Ausdehnungskoeffizient von 4,4 bis 5,3·$10^{-6}$ 1/K ähnlich dem des Substratmaterials GaAs (5,7·$10^{-6}$ 1/K) ist, welches typischerweise für VCSEL verwendet wird. Dies ist vorteilhaft, das damit das Auftreten von mechanischen Spannungen bei unterschiedlichen Temperaturen vermieden werden kann. Ein weiteres bevorzugtes Material ist Aluminiumoxid.

Bevorzugt umfasst die Oberfläche des Trägerelements ein Metall. Die Oberflächenemitter sind dabei vorzugsweise direkt auf dem Trägerelement (dem Metall) mit einem Anschluss (z.B. der Kathode) elektrisch leitend aufgebracht, z.B. aufgelötet.

Die Oberflächenemitter sind sehr nahe beieinander angeordnet. Bevorzugt ist ihr Abstand a zueinander nicht größer als 1 cm, insbesondere nicht größer als 5 mm. Da der Temperaturunterschied der Außenseiten der Oberflächenemitter im Betrieb sehr klein sein soll und die Gesamttemperatur bevorzugt in einem schmalen Betriebsbereich liegen sollte, fällt ihre thermische Ausdehnung kaum ins Gewicht. Daher können sich die Oberflächenemitter durchaus auch berühren. Eine bessere Wärmeleitfähigkeit des Trägerelements erlaubt einen vergleichsweise großen Abstand zwischen den Oberflächenemittern, bei einer schlechteren Wärmeleitfähigkeit des Trägerelements sollte ein kleinerer Abstand zwischen den Oberflächenemittern gewählt werden. Das Verhältnis V des Abstands a zwischen zwei Oberflächenemittern und der effektiven Wärmeleitfähigkeit w des Trägermaterials V = w / a ist gemäß der Erfindung, größer als 5000 W/(m²·K), insbesondere größer als 20000 W/(m²·K), besonders bevorzugt größer als 50000 W/(m²·K). Je nach der Wärmeleitfähigkeit des Trägermaterials und des verwendeten Aufbaus der Anordnung der Oberflächenemitter ist es auch bevorzugt, dass V größer ist als 100000 W/(m²·K), insbesondere größer als 150000 W/(m²·K), besonders bevorzugt größer als 200000 W/(m²·K). Als Abstand a wird der Abstand zumindest zwischen den aktiven Bereichen der Oberflächenemitter angesehen, da dies die kritische Bereiche bezüglich einer thermischen Kopplung sind. Bei Oberflächenemittern, die vergleichsweise klein sind bzw, deren Wandungen vom Housing sehr dünn sind, kann der Abstand a auch der Abstand zwischen den äußeren Oberflächen sein. Da es von Vorteil ist, wenn die Oberflächenemitter klein sind (z.B. VCSL), ist es bevorzugt, dass der Abstand a der Abstand zwischen den äußeren Oberflächen der jeweils zugewandten Seiten der Oberflächenemitter ist. Dies ist auch bei einer praktischen Konstruktion viel einfacher zu realisieren.

Die Oberflächenemitter, z.B. VCSEL, sollten nebeneinander so nah wie technische möglich positioniert werden, damit eine direkte Beziehung zwischen ihren Temperaturen besteht. Jedoch sollte eine direkte Überkopplung der Temperatur der aktiven Zone im Oberflächenemitter (der Region, in der die Laserstrahlung erzeugt wird) vermieden werden. Für VCSEL bedeutet die z.B., dass diese sehr nahe zueinander positioniert sein können, jedoch ohne dass sich deren Substrate im Bereich der aktiven Zone berühren.

Es ist je nach Anwendung im Rahmen von VCSL bevorzugt, benachbarte VCSEL von einem Wafer zu verwenden, ohne diese voneinander zu trennen. Es ist somit möglich, dass sich zumindest zwei Oberflächenemitter auf dem gleichen Substrat befinden. Jedoch sollte dann, gemäß der Erfindung, der Abstand beider Oberflächenemitter (VCSEL) zueinander mindestens 1 mm betragen, um ein Überkoppeln der Temperatur zu verhindern. Mit einem solchen Abstand berühren sich die aktiven Zonen der Oberflächenemitter in der Regel nicht mehr.

Bevorzugt dient das Trägerelement als Wärmesenke. Als Wärmesenke werden Bauteile angesehen, die eine schnelle Wärmeleitung sowie einen Wärmeaustausch mit der Umgebung erlauben. Die Dimensionen der Wärmesenke, insbesondere ihre Dicke, sind so bemessen, dass ein ausreichender Wärmefluss zwischen den Oberflächenemittern zum einen und der Umgebung zum anderen möglich ist. Bevorzugt ist das Trägerelement dicker als 0,1 mm, insbesondere dicker als 1 mm. Die Temperatur des Trägerelements kann ggf. geregelt werden, wie weiter unten genauer erklärt wird.

Ein Oberflächenemitter hat eine bestimmungsgemäße Wellenlänge (Grundwellenlänge), mit der er im Datenblatt ausgezeichnet ist. Bei konstanter Temperatur und Stromstärke ist die emittierte Wellenlänge eines VCSEL konstant. Die Wellenlänge hängt von der Stromstärke ab, mit der der Oberflächenemitter betrieben wird. In diesem Beispiel kann angenommen werden, dass die Wellenlänge $\lambda$ und die Stromstärke I über die Gleichung $\lambda$ = I · 0,6 nm/mA zusammenhängen. Betrachtet man die Oberflächentemperatur T des VCSEL, so kann man beobachten, dass die Wellenlänge $\lambda$ über $\lambda$ = T · 0,06 nm/K mit dieser Oberflächentemperatur zusammenhängt. Es ist bevorzugt, dass mindestens zwei Oberflächenemitter die gleiche bestimmungsgemäße Wellenlänge haben und mit unterschiedlichen Stromstärken betrieben werden. Damit lassen sich synthetische Wellenlängen bis in den Millimeterbereich hinein erzeugen.

Der Zusammenhang zwischen der Wellenlänge (Grundwellenlänge) und der Stromstärke resultiert aus der lokalen Erwärmung des Halbleiterchips und einer damit verbundenen Ausdehnung des Resonators. Dazu ist die eingetragene Gesamtwärmemenge in den Halbleiterkristall pro Zeiteinheit jedoch vergleichsweise gering und der erwärmte Bereich vergleichsweise klein. Durch die geringe Dicke der Laser-aktiven Schicht mit einer Resonatorlänge von typisch 2 bis 5 $\mu$m ist die thermische Relaxationszeit gering und die Wellenlänge bei Variation der Stromstärke schnell einstellbar. Die oben genannte Abhängigkeit von der Stromstärke betrifft somit eine lokal sehr eng begrenzte Erwärmung innerhalb des Oberflächenemitters, die Abhängigkeit von der Temperatur eine Erwärmung des gesamten Oberflächenemitters.

Es ist besonders bevorzugt, dass die Oberflächenemitter die gleiche bestimmungsgemäße Wellenlänge haben. Dies stellt auf den ersten Blick einen Widerspruch dar, der jedoch sofort aufgelöst werden kann. Bisher angebotene VCSEL haben Wellenlängenunterschiede größer als 10 nm. So würde eine extreme Kombination auf dem Markt erhältlicher VCSEL (s.o.) mit 795 nm und 940 nm gemäß der oben erwähnten Formel (1) eine synthetische Wellenlänge $\Lambda_S$ = 5,2 $\mu$m emittieren. Die am engsten benachbarten Grundwellenlängen 852nm und 895 nm ergeben $\Lambda_S$ = 17,8 $\mu$m. Da Licht mit Wellenlängen im $\mu$m-Bereich auch direkt von Lasern emittiert werden kann, kann die Relevanz einer Erzeugung vergleichbarer synthetischer Wellenlängen in der Praxis einen geringen Stellenwert aufweisen. Deutlich größere synthetische Wellenlängen werden hingegen erreicht, wenn gleichartige VCSEL (gleiche bestimmungsgemäße Wellenlänge) bei unterschiedlichen Stromstärken betrieben werden. Je nach Typ lässt sich die Stromstärke sinnvoll über einige mA variieren, was bei dem oben genannten Faktor von 0,6 nm/mA einen Wellenlängenunterschied im einstelligen nm-Bereich oder sogar im pm-Bereich zulässt. Für ein VCSEL-Paar mit einer Grundwellenlänge von 852 nm führt ein Wellenlängenunterschied von 1 nm zu einer synthetischen Wellenlänge im mm-Bereich.

Es ist bevorzugt, dass zumindest zwei der Oberflächenemitter Grundwellenlängen haben, die sich voneinander um weniger als 10 nm unterscheiden, bevorzugt weniger als 5 nm. Da sich Oberflächenemitter einer gleichen bestimmungsgemäßen Wellenlänge wegen Fertigungstoleranzen durchaus um einige nm bezüglich der Grundwellenlänge unterscheiden können, ist es auch möglich neben einer Stromregelung oder zusätzlich zu dieser zwei Oberflächenemitter (z.B. VCSEL) zu verwenden, welche bei gleicher Stromstärke einen Wellenlängenunterschied aufweisen, der dem der benötigten synthetischen Wellenlänge entspricht. Bevorzugt werden dabei Oberflächenemitter mit derselben nominellen Grundwellenlänge (bestimmungsgemäßen Wellenlänge) verwendet, deren reale Wellenlängen sich wegen Fertigungstoleranzen um mehr als 0,01 nm unterscheiden, bevorzugt um 0,1 nm oder mehr. Die Wellenlängen unterscheiden sich jedoch bevorzugt um weniger als 10 nm, bevorzugt um weniger als 5 nm, besonders bevorzugt um weniger als 1 nm.

Es wird noch darauf hingewiesen, dass die Grundwellenlängenpaare bei einer gewünschten Vermessung von rauen Oberflächen vorzugsweise so gewählt werden sollten, dass keine Speckle-Decorrelation auftritt (s. z.B. S. Montresor, and P. Picart, "Quantitative appraisal for noise reduction in digital holographic phase imaging," Opt. Expr. 24(13), 14322-14343 (2016)). Eine solche hätte für die resultierende Topographiekarte ein erhöhtes Rauschen zur Folge.

Gemäß einer bevorzugten Ausführungsform umfasst die Vorrichtung einen Temperatursensor und besonders bevorzugt ein Temperaturregelelement und eine Temperaturregeleinheit für eine Regelung der Temperatur eines Oberflächenemitters und/oder des Trägerelements. Bevorzugte Temperatursensoren sind Thermowiderstände oder Halbleitersensoren, bevorzugte Temperaturregelelemente sind Heizelemente, wie z.B. Heizdrähte, Kühlelemente oder Elemente, die sowohl zum Heizen als auch zum Kühlen geeignet sind, bevorzugt thermoelektrische Elemente, z.B. Peltierelemente. Insbesondere umfasst ein Temperaturregelelement eine Kombination aus den vorgenannten Elementen, z.B. ein Peltier-Element kombiniert mit einem Heizelement für die Feinabstimmung. Die Temperaturregeleinheit kann eine Schaltung sein, die eine direkte Rückkopplung zwischen Temperatursensor und Temperaturregelelement erlaubt oder eine aktiv regelnde Schaltung.

Bei der Verwendung eines thermoelektrischen Elements (z.B. einem "thermoelectric cooler" TEC) können sich die Oberflächenemitter theoretisch überall auf dem Element befinden, da die Temperatur auf dessen Oberfläche im Grunde überall gleich ist. Sie sollten sich jedoch bevorzugt nicht berühren, zumindest nicht bezüglich der aktiven Zonen. Es ist besonders bevorzugt, dass das thermoelektrische Element einen ähnlichen Wärmeausdehnungskoeffizienten hat, wie der Oberflächenemitter, um mechanische Spannungen zu vermeiden. Ein bevorzugtes Material ist diesbezüglich Aluminiumoxid ($Al_2O_3$) mit einem Wärmeausdehnungskoeffizienten im Bereich von 4,5 bis 10,9·$10^{-6}$ 1/K), besonders bevorzugt mit einem Gold-Finish. Bevorzugt ist auch Aluminiumnitrid, welches bereits oben erwähnt worden ist.

Die Anforderung an die Stabilität der synthetischen Wellenlängen hängt von der Art ihrer Nutzung ab. Für topographische Messverfahren, z.B. iterative Phasenrekonstruktionsverfahren, direkte Phasenrekonstruktionsverfahren (z. B. Transport of Intensity), interferometrische Messverfahren oder holographische Messverfahren, sollten Messabweichungen möglichst weniger als 0,1% des Messbereichs, also der synthetischen Wellenlänge, betragen. Bei synthetischen Wellenlängen im mm-Bereich muss dann die Wellenlängendifferenz zwischen den verwendeten Grundwellenlängen im pm-Bereich konstant sein (s. Formel (1)). Die Bandbreite eines Oberflächenemitters ist hierfür ausreichend klein. Bei einer Temperaturdrift von 60 pm/K müssen die Temperaturen der beiden Oberflächenemitter allerdings auf etwa 0,01 K stabilisiert werden.

Eine relative Stabilisierung erreicht das Trägerelement. Eine absolute Stabilisierung, die nicht mehr so genau sein muss, kann mit der vorangehend beschriebenen Temperaturregelung erreicht werden. Zur absoluten Stabilisierung kann die folgende Beispielrechnung zur Anschauung dienen: Bei den Grundwellenlängen $\lambda_1$ und $\lambda_2$ von 853,00 nm und 852,00 nm ergibt sich eine synthetische Wellenlänge $\Lambda_S$ von 726,76 $\mu$m. Erhöht man die Temperatur der beiden Oberflächenemitter zusammen um 1 K, ergeben sich für $\lambda_1$ und $\lambda_2$ Grundwellenlängen von 853,06 nm und 852,06 nm und für die synthetische Wellenlänge $\Lambda_{S'}$ = 726,86 $\mu$m, was tolerierbar ist. Würde sich hingegen nur ein einziger Oberflächenemitter um 1K erwärmen (z.B. $\lambda_1$ und $\lambda_2$ wären 853,06 nm und 852,00 nm), so ergäbe sich eine synthetische Wellenlänge $\Lambda_{S'}$ = 770,4 $\mu$m.

Folglich würde sich selbst bei einer Temperaturänderung von 1 K von beiden Oberflächenemittern gleichzeitig die synthetische Wellenlänge nur im Promille-Bereich ändern. Somit folgt, dass die Temperaturregelung der Vorrichtung so ausgelegt sein soll, dass sie die Temperatur der Oberflächenemitter bzw. des Trägerelements auf 1 K oder besser konstant hält.

Diese Vorrichtung hat den Vorteil, dass sie eine kompakte Lichtquelle zur Verfügung stellt, die eine zeitlich stabile synthetische Wellenlänge aus zwei Grundwellenlängen erzeugen kann, wobei die Grundwellenlängen bei Bedarf auch trennbar sind. Im Vergleich zum Stand der Technik weist die erfindungsgemäße Vorrichtung sehr wenige Bauteile auf und ist sehr robust gegenüber mechanischen und thermischen Belastungen und kostengünstiger realisierbar.

Zur Beobachtung einer Wellenlängenänderung bei spektral nicht stabilisierten Lichtquellen sind Spektrometer oder Wavemeter (die eine höhere spektrale Auflösung liefern) notwendig, da andernfalls das ermittelte Phasenbild nicht in ein wahrheitsgetreues Topographiemuster umgerechnet werden kann, was eine extreme Erhöhung der Messunsicherheit mit sich bringt. Da die erfindungsgemäße Vorrichtung eine spektral stabilisierte Lichtquelle darstellt, können mit ihr insbesondere auch Messungen ohne Spektrometer oder Wavemeter durchgeführt werden.

Ein Betrieb von zwei VCSEL mit unterschiedlichen Stromstärken kann mittels zweier unabhängiger Energieversorgungseinheiten erreicht werden, die bevorzugt regelbar sind, z.B. mittels zwei Spannungsreglern. Es ist aber auch möglich, beide VCSEL mit einer einzigen Energieversorgungseinheit mit Strom zu versorgen. Dazu ist bevorzugt eine VCSEL mit einer Parallelschaltung aus einer VCSEL und einem Widerstand in Reihe geschaltet. Im Falle, dass weitere VCSEL verwendet werden sollen, können diese ebenfalls mit einem Widerstand parallelgeschaltet werden und diese Parallelschaltung in die Reihenschaltung aufgenommen werden. Die Widerstände haben dabei bevorzugt alle einen unterschiedlichen Widerstandswert. Selbstverständlich kann bei einer Verwendung von mehr als zwei VCSEL auch eine Mischform vorliegen, bei der eine Gruppe von VCSEL in einer vorgenannten Reihenschaltung vorliegt und eine andere Gruppe mit einer weiteren Energieversorgungseinheit mit Energie versorgt wird.

Eine bevorzugte Steuerung oder Regelung einer Grundwellenlänge kann bei der Verwendung mehrerer Energieversorgungseinheiten durch Steuerung bzw. Regelung einer Energieversorgungseinheit erreicht werden. In einer vorgenannten Reihenschaltung sind die Widerstände insbesondere steuer- oder regelbar, z.B. in Form eines Potentiometers oder einer Zuschaltung unterschiedlicher Widerstände.

Da über den Widerstand der VCSEL ein direkter Zusammenhang zwischen Spannung und Strom vorliegt, kann auch gesagt werden, dass jede VCSEL eine individuelle Stromquelle aufweisen muss. Dies könnte mit zwei Spannungsreglern oder der vorgenannten Reihenschaltung erreicht werden, da die Parallelschaltung mit dem Widerstand für die VCSEL wie eine individuelle Stromquelle wirkt.

Betrachtet man herkömmliche VCSEL, so sollte die Genauigkeit der Stromregelung im Bereich weniger $\mu$A liegen. Bevorzugt ist die Stromregulierung so ausgestaltet, dass Stromschwankungen kleiner als 10 $\mu$A sind. Bevorzugt sollte die Vorrichtung mindestens ein Regelelement aufweisen, mit dem die Stromstärke zumindest für einen Oberflächenemitter, insbesondere für einen Teil der Oberflächenemitter oder jeden, separat verändert und auf einen stabilen Wert geregelt werden kann.

Bevorzugt ist die Vorrichtung so ausgestaltet, dass die Intensitäten der Lichtemission von mindestens zwei der Oberflächenemitter unabhängig voneinander geändert werden können und insbesondere mindestens zwei Oberflächenemitter oder Auskoppeleinheiten so schaltbar sind, dass sie wechselseitig Licht emittieren. Dies kann durch eine direkte Steuerung der Energiezufuhr der Oberflächenemitter erreicht werden, oder auch durch Regelung der Lichtstrahlen z.B. mittels einer Blende oder einem Element, dessen Transmission gesteuert werden kann, z.B. einem LCD-Element, einem akustooptischen-Modulator oder einer Pockels-Zelle in Verbindung mit einer Polarisationsoptik. Eine Regelung der Lichtstrahlen unabhängig von der Energiezufuhr der Oberflächenemitter hat den Vorteil, dass die Wellenlänge der emittierten Strahlung sehr konstant gehalten werden kann. Diese Ausführungsform, insbesondere die wechselseitige Schaltung von Lichtstrahlen hat den Vorteil dass bei einer Messung verschiedene Grundwellenlängen nacheinander aufgenommen werden können. Es wird darauf hingewiesen, dass die Intensität der Lichtemission nicht zwingend direkt an den Oberflächenemittern geschaltet werden muss, sondern im Grunde irgendwo im Strahlengang geschaltet werden kann, z.B. auch an einer Auskoppeleinheit.

Gemäß einer bevorzugten Ausführungsform umfasst die Vorrichtung ein Lichtleitsystem, welches dazu ausgelegt ist, die Lichtstrahlen der VCSEL zu leiten.

Dies kann eine separate Führung der Strahlen sein und/oder ein Zusammenführen. Beispielsweise können die Strahlen jeder VCSEL geteilt werden, wobei zwei Bündel unterschiedlicher VCSEL danach zusammengeführt werden und zwei andere Strahlen getrennt weitergeführt werden. Das Lichtleitsystem umfasst dazu bevorzugt Spiegel (z.B. einen Dachkantenspiegel), Strahlteiler und/oder Lichtleiter (z.B. Glas- oder Kunststofffasern).

Dabei ist es besonders bevorzugt, auf die VCSEL direkt einen Lichtleiter aufzubringen, z.B. mittels kleben oder klemmen. Lichtleiter mit kreisförmigem Querschnitt sind besonders vorteilhaft, da VCSEL ein rotationssymmetrisches Abstrahlprofil haben und sich dadurch gut in diese kreisförmigen Lichtleiter einkoppeln lassen. Soll mit polarisiertem Licht gearbeitet werden (eine Single Mode VCSEL emittiert oftmals linear polarisiertes Licht), umfasst das Lichtleitsystem bevorzugt zusätzlich Polarisationselemente. Auch eine Auskoppeleinheit kann Teil des Lichtleitsystems sein. Bei einer bevorzugten Verwendung von Lichtleitern ist ein Lichtleiter direkt auf den Ausgang eines Oberflächenemitters lichtdurchlässig gebondet, beispielsweise mittels einer Epoxidharzverbindung.

Bei einer Zusammenführung von zwei Strahlen kann dieser Teil des Lichtleitsystems auch als "Vereinheitlichungseinheit" bezeichnet werden. Bevorzugte Vereinheitlichungseinheiten umfassen eine Zusammenführung zweier Lichtleiter, einen Strahlteiler (als Würfel oder Platte) oder andere komplexere optische Elemente.

Bevorzugte Konfigurationen sind dabei die erwähnte Zusammenführung zweier Lichtstrahlen in eine Auskoppeleinheit bzw. die separate Führung und Auskopplung zweier Lichtstrahlen mittels zweier Auskoppeleinheiten, sowie eine zunächst separate Führung und anschließende Zusammenführung zweier Lichtstrahlen in einem Strahlteiler. Es ist dabei durchaus bevorzugt, dass die Auskopplung eines Referenzstrahls und die Auskopplung eines Objektstahls separat, insbesondere in Form einer unterschiedlichen Auskopplung erfolgt. z.B. kann der Objektstahl in Form einer Zusammenführung zweier Lichtstrahlen ausgekoppelt werden und der Referenzstrahl in Form zweier polarisierter Lichtstrahlen, die mittels eines Strahlteilers zusammengeführt werden.

Die Auskopplung von Licht aus einer lichterzeugenden Vorrichtung und damit die vorgenannten Auskoppeleinheiten sind hinlänglich bekannt. Da die erfindungsgemäße Vorrichtung Licht emittieren soll, umfasst sie automatisch auch eine Anzahl von Auskoppeleinheiten. Eine einfache Auskoppeleinheit kann eine Öffnung, ein Fenster oder das Ende eines Lichtleiters sein. Bevorzugt umfasst eine Auskoppeleinheit Linsen bzw. Linsensysteme zur Manipulation (z.B. Aufweitung oder Bündelung) des emittierten Lichts.

Es ist für einige Anwendungen bevorzugt, dass die Vorrichtung mehr als zwei VCSEL aufweist. Zwar sind zur Erzeugung einer synthetischen Wellenlänge nur zwei Grundwellenlängen notwendig, jedoch besteht bei mehr als zwei Grundwellenlängen die vorteilhafte Möglichkeit, dass mehrere synthetische Wellenlängen gleichzeitig erzeugt werden können. Dies kann zum Beispiel sinnvoll sein, um einen Topographiesensor zu bauen, der bei größeren Abständen Mehrdeutigkeitsprobleme durch die Kombination von unterschiedlichen Wellenlängen löst und so einen sehr großen Messbereich mit hoher Genauigkeit kombinieren kann.

Die Laseremission von Oberflächenemittern kann neben der Hauptwellenlänge noch Seitenbänder mit etwas kürzerer oder längerer Wellenlänge aufweisen. Auch wenn diese Seitenbänder in der Regel eine deutlich geringe Intensität als die Hauptwellenlänge haben, ist es bevorzugt, dass die Vorrichtung ein Filterelement im Strahlengang einer (insbesondere jeder) VCSEL aufweist. Wobei die Filter natürlich so bemessen sind, dass die Seitenbänder entfernt werden, die Hauptwellenlängen natürlich nicht. Insbesondere bei einer Übertragung der Strahlung über Lichtleiter ist es bevorzugt die Filter ein- und/oder auskoppelseitig anzubringen. Werden zwei Filterelemente benutzt, kann auch einer einkoppelseitig und der andere auskoppelseitig relativ zu einem Element eines Lichtleitsystems platziert werden. Bevorzugt umfasst eine vorgenannte Auskoppeleinheit ein Filterelement.

Die Filter werden vorzugsweise individuell für jeden VCSEL in den Strahlengang gebracht. Vorzugsweise wird dazu ein Bandbass-Filter eingesetzt, bei dem die Hauptwellenlänge der VCSEL in den Transmissionsbereich und die Seitenbänder in den Absorptionsbereich fallen. Für den Fall, dass verfügbare Filter hierzu nicht schmalbandig genug sein sollten, kann der Transmissionsbereich auch über die Kombination von zwei Filtern auf die erforderliche geringe Spektralbreite verringert werde. Hierzu ist es bevorzugt zwei oder mehr Bandpassfilter mit einer leicht unterschiedlichen Zentralwellenlänge zu verwenden, was z.B. durch Aussortierung aus einer Chargenstreuung erreicht werden kann. Alternativ kann der Spektralbereich auch durch Verkippung eines Filters angepasst werden, da die spektrale Transmission oftmals vom Einfallswinkel abhängig ist.

Im Folgenden werden bevorzugte Vorrichtungen für topographische Messverfahren bzw. Messapparaturen beschrieben, also z.B. für eine iterative Phasenrekonstruktion, interferometrische Messungen (womit auch die Shearing Interferometrie oder Messungen im Rahmen der Ptychographie gemeint sind) oder holographische Messungen (womit auch Gabor-Inline Holographie gemeint ist), die sich mit der erfindungsgemäßen Vorrichtung vorteilhaft realisieren lassen und gute Messergebnisse liefern. Unter interferometrischen bzw. holographischen Messverfahren werden im Rahmen der Erfindung alle quantitativen Phasenrekonstruktionsverfahren verstanden, die auf der Überlagerung von Lichtwellen basieren. Dabei kann mit Hilfe eines Referenzstrahls aber auch ohne einen Referenzstrahl gemessen werden, z.B. bei einer iterativen Ermittlung einer komplexen Amplitudenverteilung eines Objektes (s. z.B. R. Gerchberg and W. Saxton, "Phase determination for image and diffraction plane pictures in the electron microscope," Optik 34, 275-284 (1971). J. Fienup, "Reconstruction of an object from the modulus of its Fourier transform," Optics Letters 327-29 (1978) oder zur Ptychography, H. Faulkner und J. Rodenburg, "Moveable aperture lensless transmission microscopy: a novel phase retrieval algorithm," Phy. Rev. Lett., 93(2) 023903/1-4 (2004)), oder zur nicht iterativen Ermittlung der komplexen Amplitudenverteilung (s. z.B. das Prinzip des Tansport of Intensity (TIE)).

Eine erfindungsgemäße Messvorrichtung umfasst stets eine erfindungsgemäße Vorrichtung und einen optischen Sensor (zum Erfassen der Grundwellenlängen und der synthetischen Wellenlänge). Zudem sollte ein bestimmungsgemäßer Messbereich definiert sein, in dem ein Objekt vermessen werden kann. Da ein Objekt zur Vermessung besonders bevorzugt mit der synthetischen Wellenlänge beleuchtet werden sollte, ist es bevorzugt, dass die Strahlen mindestens zweier Oberflächenemitter der Vorrichtung zur Beleuchtung des Messbereichs stets zusammengeführt werden (bevor sie aus der betreffenden Auskoppeleinheit der Vorrichtung austreten).

Der optische Sensor kann ein (linearer oder flächiger) Bildsensor sein, also ein Sensor, der ein lineares oder flächiges Bild mit mehreren Bildpunkten aufnimmt, oder aber auch ein Punktsensor, also ein optischer Sensor mit einem einzigen Bildpunkt, z.B. ein Photoelement.

Zusätzlich umfasst die Messvorrichtung bevorzugt noch eine oder mehrere der folgenden Komponenten:

- Ein optisches Element, vorzugsweise ein Element aus der Gruppe Strahlteiler, Spiegel (insbesondere dichroitische Spiegel), Prismen und Linsen. Bevorzugt umfasst das optische Element ein Umlenkelement zum Umlenken des Strahls. Alternativ kann auch ein Faserende eines Lichtleiters so platziert werden, dass es das Objekt direkt beleuchtet. Besonders bevorzugt ist, dass ein Umlenkelement mit einer Linse oder einem Linsensystem kombiniert wird, mit dem das aus der Vorrichtung austretende Licht vorzugsweise kollimiert und senkrecht auf das zu untersuchende Objekt gerichtet wird.ie von der Lichtquelle kommende Objektfaser AasVCSEL emittierte Licht der zumindest beiden Wellenlängen BCCA

- Ein Auswertemodul zur Ermittlung des vom optischen Sensor aufgenommenen Phasensignals entsprechend einer synthetischen Wellenlänge, insbesondere durch Differenzbildung der zumindest zwei quantitativen Phasensignalen entsprechend der Grundwellenlänge. Die synthetische Wellenlänge wird aus den Grundwellenlängen insbesondere entsprechend der Formel (1) ermittelt.

- Eine Bewegungseinheit zur Bewegung eines zu vermessenden Objekts in einem bestimmungsgemäßen Messbereich. Eine solche Bewegungseinheit ist besonders vorteilhaft, wenn eine Punktmessung oder Ptychography durchgeführt werden soll. Bei einer herkömmlichen interferometrischen bzw. holografischen Anordnung ist sie nicht unbedingt notwendig, da hier oftmals flächig gemessen wird, sie könnte aber vorteilhaft zur Justage oder andere Verstellungen des Objekts sein.

- Eine Anordnung einer Auskoppeleinheit der Vorrichtung, welche einen Referenzstrahl mit einer separat geführten Grundwellenlänge direkt oder über ein optisches Element (z.B. Spiegel) abgelenkt auf den optischen Sensor leitet, so dass eine holographische Aufnahme erreicht wird. Der Lichtstrahl kann dabei etwas schräg auf den optischen Sensor treffen, um eine Trägerfrequenz zu erzeugen, welche die gleichzeitige Aufnahme mehrerer wellenlängenspezifischer Holgramme ermöglicht (eine Trägerfrequenz mit unterschiedlichen Richtungen, die eine Separation im Fourierraum ermöglicht), wobei bevorzugt ein Lichtstrahl schräg von oben bzw. unten auf den optischen Sensor auftrifft und ein zweiter mit einer anderen Wellenlänge schräg von der Seite.

- Eine Auskoppeleinheit, welche zwei unterschiedliche Grundwellenlängen unterschiedlicher Polarisation aussendet, wobei die Messeinheit bevorzugt zwei optische Sensoren, insbesondere Punktsensoren, aufweist und eine optische Einheit, z.B. ein Polarisationsstrahlteiler(würfel), welche dazu ausgestaltet ist, Licht mit unterschiedlichen Polarisationen in unterschiedliche Richtungen (auf die optischen Sensoren) zu lenken.

- Eine Abbildungsoptik, welche ein Bild des Objekts erzeugt (insbesondere durch eine Apertur hindurch), welches so positioniert ist, dass es durch den optischen Sensor (z.B einen Punktsensor) aufgenommen wird.

Eine bevorzugte Messvorrichtung ist zu einer Messung mit einem Referenzstrahl ausgelegt, wobei der Objektstrahl (der auf das Objekt gerichtete und von diesem reflektierte Strahl) mit dem Referenzstrahl auf einem Bildsensor interferiert. Hier kann der optische Sensor ein Bildsensor zur Aufnahme eines flächigen Bildes sein oder aber je nach Aufnahmemodus auch ein Punktsensor. Für andere Anwendungen kann die Messvorrichtung auch ohne einen Referenzstrahl messen, also nicht auf die Interferenz des Objektstrahls mit einem Referenzstrahl angewiesen sein. Hier ist eine sequentielle Aufzeichnung mittels eines Punktsensors als optischer Sensor bevorzugt. Auch ist eine zeitlich parallele Aufzeichnung mittels einer Polarisationsoptik bevorzugt (mit einem Punktsensor oder einem flächigen Bildsensor). Gemäß einer weiteren bevorzugten Ausführungsform ist die Messvorrichtung zu einem Messverfahren basierend auf Selbstinterferenz ausgelegt wie zum Beispiel zur Shearing Interferometrie oder Gabor-Inline Holographie. Für eine Snapshotmessung, ist die Messvorrichtung bevorzugt so ausgestaltet, dass die zugehörigen Referenzstrahlen so angeordnet sind, dass die jeweiligen wellenlängenspezifischen Informationen mittels Fouriertransformation des aufgenommen Hologramms trennbar sind.

Beispiele für bevorzugte Ausführungsformen der erfindungsgemäßen Vorrichtung sind in den Abbildungen schematisch dargestellt.

Figur 1 zeigt ein Ausführungsbeispiel für eine erfindungsgemäße Vorrichtung.
Figur 2 zeigt ein Ausführungsbeispiel für eine erfindungsgemäße Vorrichtung mit einer alternativen Auskopplung.
Figur 3 zeigt einen Grundaufbau einer bevorzugten Messvorrichtung.
Figur 4 zeigt einen Grundaufbau einer weiteren bevorzugten Messvorrichtung.
Figur 5 zeigt einen Grundaufbau einer weiteren bevorzugten Messvorrichtung.
Figur 6 zeigt einen Grundaufbau einer weiteren bevorzugten Messvorrichtung.
Figur 7 zeigt einen Grundaufbau einer weiteren bevorzugten Messvorrichtung.
Figur 8 zeigt einen Grundaufbau einer weiteren bevorzugten Messvorrichtung.

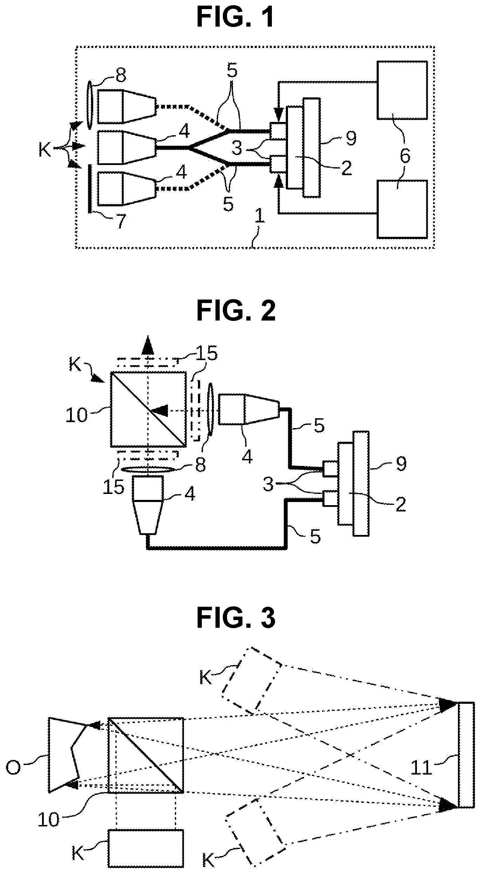

Figur 1 zeigt ein Ausführungsbeispiel für eine erfindungsgemäße Vorrichtung 1 zur Erzeugung einer synthetischen Wellenlänge. Diese Vorrichtung 1 umfasst ein wärmeleitendes Trägerelement 2, auf das zwei Oberflächenemitter 3 aufgebracht sind. Es kann beispielsweise angenommen werden, dass das Trägerelement 2 ein Kupferblock ist und beide Oberflächenemitter 3 auf dem Trägerelement 2 aufgelötet sind. VCSEL 3 sind mit einer Baugröße mit einem Durchmesser von in der Regel ca. 5 mm klein. Sie lassen sich dadurch eng (< 6 mm) aneinander positionieren.

Das Trägerelement 2 wird je nach Bedarf durch ein Temperaturregelelement 9 gekühlt oder erwärmt. Die Vorrichtung kann zur Regelung des Temperaturregelelements 9 noch einen (nicht dargestellten) Temperatursensor sowie eine (ebenfalls nicht dargestellte Temperaturregeleinheit umfassen.

Die beiden Oberflächenemitter werden durch jeweils eine Energieversorgungseinheit 6 mit Strom einer vorbestimmten Spannung versorgt. Zur korrekten Energieversorgung kann eine Energieversorgungseinheit 6 alles umfassen, was ein Oberflächenemitter 3 für einen bestimmungsgemäßen Betrieb benötigt, z.B. einen Vorwiderstand.

Mindestens eine der Energieversorgungseinheiten 6 ist regelbar, damit die beiden Oberflächenemitter 3, die hier die gleiche bestimmungsgemäße Wellenlänge emittieren, mit jeweils unterschiedlichen Stromstärken betrieben werden können, damit sich die Grundwellenlängen etwas voneinander unterscheiden und dadurch die synthetische Wellenlänge erfindungsgemäß erzeugt werden kann. Wohlgemerkt wird kein "Lichtstrahl" mit einer synthetischen Wellenlänge erzeugt. Der bei einer Messung detektierte Wellenlängenbereich entspricht stets den emittierten Grundwellenlängen der Lichtquellen. Die synthetische Wellenlänge wird später in der Datenverarbeitung erzeugt.

Das von den Oberflächenemittern 3 erzeugte Licht wird mittels Lichtleitern 5 geführt, die das Licht an ihren Lichtleiterenden 4 austreten lassen. Dabei sind in der Figur zwei Optionen gezeigt, die jede für sich oder auch zusammen vorliegen können. Einmal können die beiden Strahlen der Oberflächenemitter 3 zusammengeführt werden, was in der Mitte dargestellt ist (durchgezogene Linien der Lichtleiter 5) und gemeinsam als Lichtstrahl zur Beleuchtung des Objekts mit den Grundwellenlängen (für eine Messung mit der synthetischen Wellenlänge) austreten. zum anderen können die beiden Strahlen der Oberflächenemitter 3 separat voneinander geführt werden, was an den Seiten dargestellt ist (gestrichelte Linien der Lichtleiter 5). Diese können später zur Erzeugung der synthetischen Wellenlänge zusammengeführt werden oder separat voneinander verwendet werden. Beispielsweise können die zusammengeführten Strahlen (durchgezogenen Linien) zur Beleuchtung des Objekts (als Objektstrahl) verwendet werden und die separat geführten Strahlen (gestrichelte Linien) als separate Referenzstrahlen der beiden Wellenlängen, so dass z.B. durch die örtliche Separation in zwei Phasenausgängen, die für eine Snapshot Anwendung notwendigen unterschiedlichen Richtungen bzw. Raumwinkel (z.B. Vertikaler und horizontaler Anstellwinkel) auf einem optischen Sensor umgesetzt werden können.

Das Licht kann direkt aus einem Lichtleiterende 4 austreten (s. Mitte), mittels einer Austrittslinse 8 aufgeweitet oder fokussiert werden oder durch ein Filterelement 7 gefiltert werden, wobei auch eine Kombination von Austrittslinse 8 und Filterelement 7 vorliegen kann. Alle diese Möglichkeiten des Lichtaustritts kann als Auskoppeleinheit K aufgefasst werden.

Kern der Vorrichtung 1 ist die Kombination des Trägerelements 2 mit den Oberflächenemittern 3. Die übrigen Komponenten sind optional und könnten theoretisch auch externe Komponenten sein.

Figur 2 zeigt ein Ausführungsbeispiel für eine erfindungsgemäße Vorrichtung mit einer alternativen Auskopplung. Hier wird das Licht der Oberflächenemitter 3 zunächst separat durch zwei Lichtleiter geführt, tritt durch die Lichtleiterenden von unterschiedlichen Seiten in einen Strahlteiler 10 ein, wird in dem Strahlteiler 10 zusammengeführt und tritt als Lichtstrahl mit den beiden Grundwellenlängen, welche die synthetische Wellenlänge erzeugen können, aus dem Strahlteiler 10 aus. Der Strahlteiler 10 oder eine Austrittsapertur (bzw. ein Austrittsfenster) kann hier als Auskoppeleinheit K angesehen werden.

Für den Fall, dass mit polarisierten Lichtstrahlen gemessen werden soll, können Polarisatoren 15 an den geeigneten Stellen angeordnet werden. In der Figur sind drei mögliche Positionen gezeigt, in denen Polarisatoren 15 (strichpunktiert) angeordnet werden können, wobei die Positionen zwischen den Linsen 8 und dem Strahlteiler 10 bevorzugt sind.

Da bei einem normalen 50%-50% Strahlteiler die Hälfte des Lichtes verloren geht, ist es vorteilhaft, an Stelle des Strahlteilers ein Element mit einem kleineren Verlust zu verwenden. Eine Dichroit ist hier z.B. vorteilhaft, da er bei einer günstigen Lage der beiden Wellenlängen die eine Wellenlänge reflektiert und die andere transmittiert und so eine verlustfreie Zusammenführung beider Strahlen erlaubt. Im Folgenden werden aber zur besseren Übersicht Strahlteiler gezeigt.

Figur 3 zeigt einen Grundaufbau einer bevorzugten Messvorrichtung. Der besseren Übersicht halber sind von einer erfindungsgemäßen Vorrichtung nur die Auskoppeleinheiten K dargestellt, diese können wie bereits vorangehend ausgeführt wurde, z.B. Lichtleiterenden 4 sein (ggf. mit Austrittslinsen und/oder Filter versehen), Austrittsfläche von Strahlteilern 10 oder Aperturen bzw. Austrittsfenster. Wichtig ist hier lediglich, dass das hier links dargestellte Objekt O mit zumindest zwei unterschiedlichen Grundwellenlängen bestrahlt wird, welche unter gleichem Winkel auf das Objekt treffen, also die Strahlen der Oberflächenemitter 3 der Vorrichtung 1 stets zusammengeführt worden sind, bevor sie aus der unteren (linken) Auskoppeleinheit K austreten.

Die hier dargestellte Messvorrichtung erlaubt eine linsenlose Aufzeichnung der Beugungsmuster der unterschiedlichen Wellenlängen, welche vom Objekt O zurück reflektiert werden. Der aus der unteren (linken) Auskoppeleinheit K austretende Lichtstrahl wird durch den Strahlteiler 10 auf das Objekt O abgelenkt, von dem Objekt O durch den Strahlteiler 10 hindurch zurück reflektiert und trifft auf den optischen Sensor 11 (s. gestrichelte Strahlengänge). Mit den aufgenommenen Informationen kann sie Oberflächenstruktur des Objekts O nach bekannten Auswertungsverfahren bestimmt werden.

Die Messvorrichtung in dieser Figur kann Messungen ohne einen Referenzstrahl durchführen. Für interferometrische oder holographische Messungen kann aber auch ein Referenzstrahl eingebracht werden, z.B. durch eine weitere Auskoppeleinheit K, eine entsprechende Strahlführung durch weitere optische Elemente oder durch Umgruppierung der dargestellten Elemente, so dass der Strahlteiler 10 das aus der Auskoppeleinheit K austretende Licht sowohl als Objektstrahl als auch als Referenzstrahl nutzt. Eine bevorzugte interferometrische bzw. holografische Ausführungsform, bei der der Objektstrahl mit schräg eingestrahlten Referenzstrahlen interferieren kann, ist im Folgenden beschrieben.

In Figur 3 ist auch gezeigt, wie die Messeinheit für eine interferometrische bzw. holographische Aufnahme modifiziert werden kann (strichpunktiert dargestellte Komponenten). Mittels zweier weiterer Auskoppeleinheiten K wird ein Referenzstrahl oder wie hier dargestellt zwei Referenzstrahlen mit den beiden separat geführten Grundfrequenzen direkt oder über optische Elemente (z.B. Spiegel) abgelenkt auf den optischen Sensor 11 geleitet. Hier treffen diese Lichtstrahlen etwas schräg auf den optischen Sensor, um Abschattungen des Objektstrahls zu vermeiden und um die für die Snapshot Aufnahme notwendige Trägerfrequenz zu generieren. Ein Lichtstrahl kann dabei schräg von oben bzw. unten auftreffen, ein anderer schräg von der Seite (Off Axis). Es ergibt sich ein Hologramm mittels dessen das Objekt mittels bekannter Auswertungsverfahren vermessen werden kann.

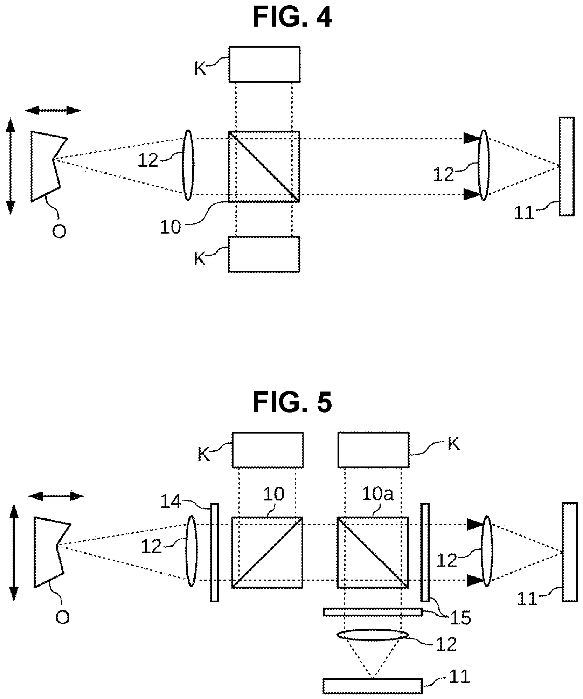

Figur 4 zeigt einen Grundaufbau einer weiteren bevorzugten Messvorrichtung in Form eines Punktdetektors. Die Messvorrichtung arbeitet mit einem Lichtstrahl, der mittels einer Linse 12 auf das Objekt in einem Punkt fokussiert wird. Das Objekt wird mittels einer (durch Pfeile symbolisierten) Bewegungseinheit während der Messung bewegt und sequentiell abgetastet. Auch hier tritt der Lichtstrahl, der das Objekt beleuchtet (wieder mit der synthetischen Wellenlänge), aus der unteren (linken) Auskoppeleinheit K aus, wird durch den Strahlteiler 10 auf das Objekt O abgelenkt, von dem Objekt O durch den Strahlteiler 10 hindurch zurückgestrahlt und trifft durch eine Linse 12 fokussiert auf den optischen Sensor 11. Aus der oberen Auskoppeleinheit K tritt für eine eine topographische (z.B. interferometrische) Messung ein Referenzstahl aus, der durch den Strahlteiler 10 auf den optischen Sensor 11 abgelenkt wird.

In einer einfachen Ausführungsform können der Objektstrahl sowie der Referenzstrahl die synthetische Wellenlänge aufweisen (bzw. die Grundwellenlängen, welche die synthetische Wellenlänge ergeben). Es ist aber alternativ auch möglich, mit polarisiertem Licht zu messen. Hierzu könnte vor den Auskoppelstellen K jeweils eine Anordnung positioniert sein, wie sie in der Figur 2 zu sehen ist, wobei die Lichtleiter Licht von jeweils einem Oberflächenemitter 3 liefern und in einem Strahlteiler 10 zusammenführen (s. Figur 2), wobei die beiden Strahlen unterschiedliche Polarisation haben (der Strahl des einen Oberflächenemitters 3 p-Polarisiert und der andere s-polarisiert). Hierzu ist es sehr von Vorteil, wenn die beiden Oberflächenemitter 3 abwechselnd geschaltet werden, so dass der optische Sensor 11 abwechselnd Strahlung mit unterschiedlicher Polarisation empfängt.

In Figur 5 ist eine Abwandlung der Figur 4 gezeigt, die insbesondere für eine simultane Vermessung mit polarisiertem Licht von Vorteil ist. Hierzu sollte aus der oberen linken Auskoppeleinheit K ein Lichtstrahl austreten, bei dem eine erste Grundwellenlänge mit einer p-Polarisation und eine zweite Grundwellenlänge mit einer s-Polarisation austritt. Dies kann z.B. mittels einer Vorrichtung gemäß Figur 2 erreicht werden. Bevorzugt sind dabei nach den beiden Lichtleiterenden entsprechende Polarisationsfilter angeordnet. Dies ist jedoch nicht zwingend notwendig, z.B. wenn das aus der Faser austretende Licht bereits polarisiert ist. Dies kann beispielsweise dadurch erreicht werden, dass linear polarisiertes Licht aus einem single mode VCSEL in eine polarisationserhaltende Faser geführt wird. Der resultierende Strahl ist auf das Objekt O gerichtet und fällt durch ein Lambda-Viertel Plättchen 14, welches die Polarisation um 45° dreht.

Aus der im Bild rechts positionierten Auskoppeleinheit K wird polarisiertes Licht der dementsprechenden Referenzstrahlen ausgekoppelt und durch einen Kombinationspolarisation-Strahlteiler 10a je nach seiner Polarisation auf einen der zwei dargestellten optischen Sensoren 11 gelenkt. Der vom Objekt O reflektierte Strahl fällt ebenfalls durch den Kombinationspolarisation-Strahlteiler 10a und wird entsprechend seiner Polarisation auf den einen oder den anderen optischen Sensor 11 geführt.

Aufgrund der zweifachen Transmission des Objektstrahls durch das um 45° gedrehte Lambda-Viertel Plättchens 14 ist die Polarisation des Objektstrahls am Kombinationspolarisation-Strahlteiler 10a um 90° gedreht. Somit kann der durch den Kombinationspolarisation-Strahlteiler 10a transmittierte p-polarisierte Objektstrahl mit dem dazugehörigen s-polarisierten Referenzstrahl auf den rechten optischen Detektor 11 in einem gemeinsamen Punkt fokussiert werden. Um eine Interferenz des Referenzstrahls und Objektstrahls zu ermöglichen wird im noch kollimierten Strahlengang ein um 45° gedrehter Polarisator 15 platziert. Eine dementsprechende Anordnung gilt auch für den unteren optischen Detektor 11, um die Interferenz des s-polarisierten Objektstrahls und p-polarisierten Referenzstrahls zu ermöglichen. Bevorzugt sind die optischen Sensoren 11 Punktsensoren.

Die Messvorrichtung kann auch eine Anordnung zur holographischen Vermessung umfassen, wie im Rahmen der Modifikation zu Figur 3 dargestellt ist.

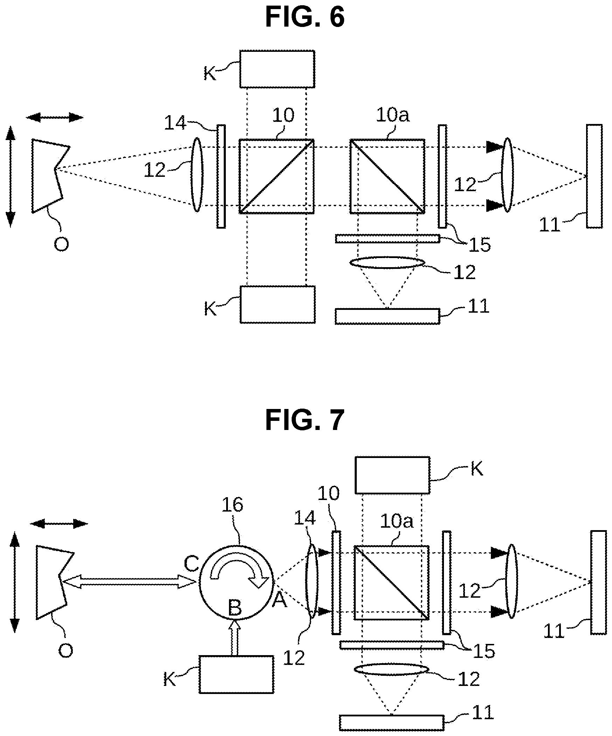

In Figur 6 ist eine Abwandlung der Figur 5 gezeigt, die insbesondere für eine simultane Vermessung mit polarisiertem Licht bei rauen Oberflächen von Vorteil ist. Hierzu tritt aus der unteren Auskoppeleinheit K ein Lichtstrahl aus, bei dem eine erste Grundwellenlänge und zweite Grundwellenlänge des Objektstrahls nicht zwingendermaßen polarisiert sind. Der Objektstrahl ist durch einen Strahlteiler 10 auf das Objekt O gerichtet und fällt durch ein um 45° gedrehten Polarisator 15. Aus der im Bild oben positionierten Auskoppeleinheit K wird polarisiertes Licht der dementsprechenden Referenzstrahlen ausgekoppelt und durch den Strahlteiler 10 und einen nachfolgenden Kombinationspolarisation-Strahlteiler 10a je nach seiner Polarisation auf einen der zwei dargestellten optischen Sensoren 11 gelenkt. Der vom Objekt O reflektierte Strahl fällt ebenfalls durch den Strahlteiler 10 und den Kombinationspolarisation-Strahlteiler 10a und wird entsprechend seiner Polarisation auf den einen oder den anderen optischen Sensor 11 geführt. Somit kann der durch den Kombinationspolarisation-Strahlteiler 10a transmittierte p-polarisierte Objektstrahl mit dem dazugehörigen s-polarisierten Referenzstrahl auf den rechten optischen Detektor 11 in einem gemeinsamen Punkt fokussiert werden.

Vorteilhaft zur Verminderung der Messunsicherheit ist die Ermittlung der Phasenlage der Wellenlänge. Dies kann durch die Positionierung eines vorzugsweise 4-Quadrantendetektors oder von vier Photodioden mit vorgeschalteter Kombination aus einem um 45° gedrehten Lambda-Viertel-Plättchen und unterschiedlich gedrehten Polarisatoren 15 ermöglicht werden, so dass die Phase entsprechend für die jeweilige Wellenlänge direkt bestimmt werden kann (s. z.B. S. Suja Helen, M.P. Kothiyal, and R.S. Sirohi, "Achromatic phase-shifting by a rotating polarizer", Opt. Comm. 154, 249 (1998)).

Eine dementsprechende Anordnung gilt auch für den unteren optischen Detektor 11, um die Interferenz des s-polarisierten Objektstrahls und p-polarisierten Referenzstrahls zu ermöglichen und die Phase zu ermitteln. Bevorzugt sind die optischen Sensoren 11 Punktsensoren.

Die Messvorrichtung kann auch eine Anordnung zur holographischen Vermessung umfassen, wie im Rahmen der Modifikation zu Figur 3 dargestellt ist.

In Figur 7 ist eine weitere Abwandlung der Figur 5 gezeigt, die einen Zirkulator 16 mit drei Koppelstellen A, B, C umfasst. An Koppelstelle B wird eine synthetische Wellenlänge aus einer Auskoppeleinheit K eingekoppelt, tritt an Koppelstelle C aus, trifft auf ein Objekt O und wird von diesem wieder reflektiert. Das reflektierte Licht tritt wieder in Koppelstelle C ein und an Koppelstelle A aus. Aus der im Bild oben positionierten Auskoppeleinheit K kann wieder polarisiertes Licht als Referenzstrahlen ausgekoppelt und durch den Kombinationspolarisation-Strahlteiler 10a je nach der Polarisation auf einen der zwei dargestellten optischen Sensoren 11 gelenkt werden. Diese Anordnung hat den Vorteil dass die Intensität des von Objekt O reflektierten Strahls vergleichsweise hoch ist.

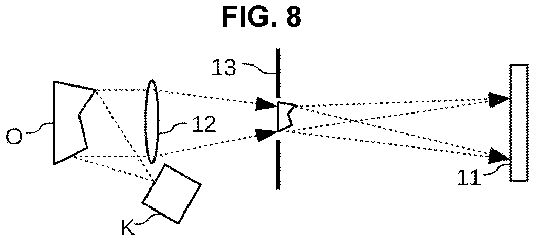

Figur 8 zeigt einen Grundaufbau einer weiteren bevorzugten Messvorrichtung, bei der das Objekt zunächst mittels einer Linse 12 durch eine Apertur 13 hindurch abgebildet wird und dieses Bild dann von einem optischen Sensor 11 fokussiert (Abstand zwischen Apertur 13 und optischem Sensor 11 innerhalb der Schärfentiefe der Optik 12) oder defokussiert (Abstand größer als Schärfentiefebereich der Optik 12) aufgenommen wird. Die Auskoppeleinheit emittiert wieder Licht mit zwei leicht unterschiedlichen Grundwellenlängen zur Erzeugung einer synthetischen Wellenlänge. Die oben beschriebenen Modifikationen sind auch hier möglich.

Es wird abschließend noch einmal darauf hingewiesen, dass die Verwendung der unbestimmten Artikel "ein" bzw. "eine" nicht ausschließt, dass die betreffenden Merkmale auch mehrfach vorhanden sein können.

Bezugszeichenliste

| 1 | Vorrichtung |
|---|---|
| 2 | Trägerelement |
| 3 | Oberflächenemitter |
| 4 | Lichtleiterende |
| 5 | Lichtleiter |
| 6 | Energieversorgungseinheit |
| 7 | Filterelement |
| 8 | Austrittslinse |
| 9 | Temperaturregelelement |
| 10 | Strahlteiler |
| 11 | Optischer Sensor |
| 12 | Linse |
| 13 | Blende |
| 14 | Lambda-Viertel Plättchen |
| 15 | Polarisator |
| 16 | Zirkulator |
| A, B, C | Koppelstelle |
| K | Auskoppeleinheit |
| O | Objekt |

**Patentansprüche**

1. Vorrichtung (1) zur Erzeugung einer synthetischen Wellenlänge umfassend mindestens zwei Oberflächenemitter (3) und ein Trägerelement (2), wobei das Trägerelement (2) ein Wärmeleiter ist und die Oberflächenemitter (3) in, an oder auf dem Trägerelement (2) fest angeordnet sind, **dadurch gekennzeichnet, dass** das Verhältnis V des Abstands a zwischen zwei Oberflächenemittern (3) und der effektiven Wärmeleitfähigkeit w des Trägermaterials $V = w / a$ größer als 5000 W/(m$^2$·K) ist, wobei sich zumindest zwei Oberflächenemitter (3) auf dem gleichen Substrat befinden und der Abstand beider Oberflächenemitter (3) zueinander mindestens 1 mm beträgt, um ein Überkoppeln der Temperatur zu verhindern.

2. Vorrichtung nach Anspruch 1, **dadurch gekennzeichnet, dass** sie einen Temperatursensor, ein Temperaturregelelement (9) und eine Temperaturregeleinheit für eine Regelung der Temperatur eines Oberflächenemitters (3) und/oder des Trägerelements (2) umfasst, bevorzugt einen Thermowiderstand oder Halbleitersensor als Temperatursensor und/oder ein Heizelement oder Kühlelemente oder Elemente, die sowohl zum Heizen als auch zum Kühlen geeignet sind, als Temperaturregelelement (9), wobei die Vorrichtung (1) besonders bevorzugt ein Peltierelement aufweist.

3. Vorrichtung nach einem der vorangehenden Ansprüche, **dadurch gekennzeichnet, dass** das Trägerelement (2) im Wesentlichen aus Materialien gefertigt ist, deren Wärmeleitfähigkeit zumindest größer als 40 W/(m·K) ist, insbesondere größer als 200 W/(m·K), und bevorzugt Aluminium oder Kupfer enthält, wobei die Oberflächenemitter (3) vorzugsweise direkt auf dem Trägerelement (3) elektrisch leitend aufgebracht sind.

4. Vorrichtung nach einem der vorangehenden Ansprüche, **dadurch gekennzeichnet, dass** das Verhältnis V des Abstands a zwischen zwei Oberflächenemittern (3) und der effektiven Wärmeleitfähigkeit w des Trägermaterials $V = w / a$ größer als 20000 W/(m$^2$·K) ist insbesondere größer als 50000 W/(m$^2$·K), wobei der Abstand der Oberflächenemitter (2) bevorzugt nicht größer als 1 cm ist, insbesondere nicht größer als 5 mm.

5. Vorrichtung nach einem der vorangehenden Ansprüche, **dadurch gekennzeichnet, dass** sie mindestens eine regelbare Energieversorgungseinheit (6) aufweist, welche eine Genauigkeit der Stromregelung im Bereich weniger µA oder unterhalb von 19 µA ermöglicht, wobei die Energieversorgungseinheit (6) bevorzugt so ausgestaltet, dass ihre Stromschwankungen kleiner als 10 µA sind.

6. Vorrichtung nach einem der vorangehenden Ansprüche, **dadurch gekennzeichnet, dass** sie mehr als zwei Oberflächenemitter (3) aufweist, die elektronisch und optisch so verschaltet sind, dass mehr als zwei Grundwellenlängen emittiert werden und zwei oder mehr synthetische Wellenlängen gleichzeitig erzeugt werden.

7. Vorrichtung nach einem der vorangehenden Ansprüche, **dadurch gekennzeichnet, dass** sie ein Lichtleitsystem umfasst, welches dazu ausgelegt ist, die Lichtstrahlen einer Anzahl von Oberflächenemittern (3) zu leiten, und bevorzugt die Strahlen zweier Oberflächenemitter (3) separat zu führen oder zusammenzuführen, wobei das Lichtleitsystem bevorzugt ein Element der Gruppe Spiegel, Strahlteiler (10), Linsen (8), Filterelemente (7), Polarisationselemente und Lichtleiter (5) umfasst.

8. Vorrichtung nach einem der vorangehenden Ansprüche, **dadurch gekennzeichnet, dass** sie eine Anzahl von Filterelementen (7) im Strahlengang einer Anzahl von Oberflächenemittern (3) umfasst, wobei die Anzahl von Filterelementen (7) so bemessen ist, dass Seitenbänder der Emissionen der Oberflächenemitter (3) entfernt werden und die Hauptwellenlängen durchgelassen werden, wobei ein Filterelement (7) bevorzugt ein- und/oder auskoppelseitig relativ zu einem Lichtleitsystem angebracht ist.

9. Vorrichtung nach einem der vorangehenden Ansprüche, **dadurch gekennzeichnet, dass** zumindest zwei Oberflächenemitter die gleiche bestimmungsgemäße Wellenlänge haben, wobei bevorzugt zumindest zwei der Oberflächenemitter Grundwellenlängen haben, die sich voneinander um weniger als 10 nm unterscheiden, bevorzugt weniger als 5 nm.

10. Vorrichtung nach Anspruch 9, **dadurch gekennzeichnet, dass** sich die Grundwellenlängen mindestens zweier Oberflächenemitter aufgrund von Fertigungstoleranzen unterscheiden.

11. Vorrichtung nach einem der vorangehenden Ansprüche, **dadurch gekennzeichnet, dass** die Oberflächenemitter so positioniert sind, dass eine Überkopplung der Temperatur aktiver Zonen der Oberflächenemitter vermieden wird, wobei die Oberflächenemitter bevorzugt Substrate umfassen und so positioniert sind, dass sich die Substrate nicht im Bereich der aktiven Zonen berühren.

12. Vorrichtung nach einem der vorangehenden Ansprüche, **dadurch gekennzeichnet, dass** sich zumindest zwei Oberflächenemitter auf einem Substrat befinden, insbesondere auf einem Wafer.

13. Vorrichtung nach einem der vorangehenden Ansprüche, **dadurch gekennzeichnet, dass** das Trägermaterial Aluminiumnitrid und/oder Aluminiumoxid umfasst oder daraus besteht.

14. Messvorrichtung zur topographischen Messung, **dadurch gekennzeichnet, dass** sie eine Vorrichtung (1) nach einem der vorangehenden Ansprüche, und einen optischen Sensor (11) umfasst.

15. Messvorrichtung nach Anspruch 14, **dadurch gekennzeichnet, dass** sie eine oder mehrere der folgenden Komponenten umfasst:

- ein optisches Element (10, 12), vorzugsweise ein Element aus der Gruppe Strahlteiler (10) Spiegel, Prismen und Linsen (12), mit dem das aus der Vorrichtung austretende Licht auf das zu untersuchende Objekt (O) gerichtet wird,
- ein Auswertemodul zur Ermittlung des vom optischen Sensor (11) aufgenommenen Phasensignals entsprechend einer synthetischen Wellenlänge, insbesondere durch Differenzbildung der zumindest zwei quantitativen Phasensignalen entsprechend der Grundwellenlänge,
- eine Bewegungseinheit zur Bewegung eines zu vermessenden Objekts (O) in einem bestimmungsgemäßen Messbereich,
- eine Anordnung einer Auskoppeleinheit (K) der Vorrichtung (1), welche einen Referenzstrahl mit einer separat geführten Grundwellenlänge direkt oder über ein optisches Element abgelenkt auf den optischen Sensor (11) leitet, so dass eine holographische Aufnahme erreicht wird,
- eine Auskoppeleinheit (K), welche zwei unterschiedliche Grundwellenlängen unterschiedlicher Polarisation aussendet, wobei die Messeinheit bevorzugt zwei optische Sensoren (11) aufweist und eine optische Einheit, welche dazu ausgestaltet ist, Licht mit unterschiedlichen Polarisationen in unterschiedliche Richtungen zu lenken,
- eine Abbildungsoptik (12), welche ein Bild des Objekts (O) erzeugt, welches so positioniert ist, dass es durch den optischen Sensor (11) aufgenommen wird.

**Claims**

1. Device (1) for generating a synthetic wavelength comprising at least two surface-emitters (3) and a carrier-element (2), wherein the carrier-element (2) is a heat conductor and the surface-emitters (3) are fixedly arranged in, at or on the carrier-element (2), **characterized in that** the ratio V of the distance a between two surface-emitters (3) and the effective thermal conductivity w of the carrier material $V = w / a$ is greater than 5000 W/(m$^2$·K), wherein at least two surface-emitters (3) are located on the same substrate and the distance between the two surface-emitters (3) is at least 1 mm to prevent cross-coupling of the temperature.

2. Device according to claim 1, **characterized in that** it comprises a temperature-sensor, a temperature-control-element (9) and a temperature-control-unit for controlling the temperature of a surface-emitter (3) and/or the carrier-element (2), preferably a thermal resistor or semiconductor sensor as a temperature sensor and/or a heating element or cooling elements or elements that are suitable for both heating and cooling as a temperature control element (9), wherein the device (1) particularly preferably comprises a Peltier-element.

3. Device according to one of the preceding claims, **characterized in that** the carrier-element (2) is essentially made of materials whose thermal conductivity is at least greater than 40 W/(m·K), in particular greater than 200 W/(m·K) and preferably contains aluminum or copper, wherein the surface-emitters (3) are preferably applied directly on the carrier-element (3) in an electrically conductive manner.

4. Device according to one of the preceding claims, **characterized in that** the ratio V of the distance a between two surface-emitters (3) and the effective thermal conductivity w of the carrier material V = w / a is greater than 20,000 W/(m²·K), in particular greater than 50,000 W/(m²·K), wherein the distance between the surface-emitters (2) is preferably not greater than 1 cm, in particular not greater than 5 mm.

5. Device according to one of the preceding claims, **characterized in that** it has at least one controllable energy supply unit (6) which enables an accuracy of the current control in the range of a few μA or below 19 μA, wherein the energy supply unit (6) is preferably designed such that its current fluctuations are less than 10 μA.

6. Device according to one of the preceding claims, **characterized in that** it has more than two surface-emitters (3) which are electronically and optically connected in such a way that more than two fundamental wavelengths are emitted and two or more synthetic wavelengths are generated simultaneously.

7. Device according to one of the preceding claims, **characterized in that** it comprises a light-guide-system which is designed to guide the light beams of a number of surface-emitters (3) and preferably to separately guide or combine the beams of two surface-emitters (3), wherein the light guide system preferably comprises an element from the group of mirrors, beam splitters (10), lenses (8), filter elements (7), polarization elements and light guides (5).

8. Device according to one of the preceding claims, **characterized in that** it comprises a number of filter elements (7) in the beam path of a number of surface-emitters (3), wherein the number of filter elements (7) is dimensioned such that sidebands of the emissions of the surface-emitters (3) are removed and the main wavelengths are allowed to pass, wherein a filter element (7) is preferably mounted on the input and/or output side relative to a light-guide-system.

9. Device according to one of the preceding claims, **characterized in that** at least two surface-emitters have the same intended wavelength, preferably wherein at least two of the surface-emitters have fundamental wavelengths that differ from one another by less than 10 nm, preferably less than 5 nm.

10. Device according to claim 9, **characterized in that** the fundamental wavelengths of at least two surface-emitters differ due to manufacturing tolerances.

11. Device according to one of the preceding claims, **characterized in that** the surface-emitters are positioned in such a way that cross-coupling of the temperature of active zones of the surface-emitters is avoided, wherein the surface-emitters preferably comprise substrates and are positioned in such a way that the substrates do not touch in the area of the active zones.

12. Device according to one of the preceding claims, **characterized in that** at least two surface-emitters are located on a substrate, in particular on a wafer.

13. Device according to one of the preceding claims, **characterized in that** the carrier material comprises or consists of aluminum nitride and/or aluminum oxide.

14. Measuring device for topographical measurement, **characterized in that** it comprises a device (1) according to one of the preceding claims, and an optical sensor (11).

15. Measuring device according to claim 14, **characterized in that** it comprises one or more of the following components:

- an optical element (10, 12), preferably an element from the group of beam splitters (10), mirrors, prisms and lenses (12), with which the light emerging from the device is directed onto the object (O) to be examined,
- an evaluation module for determining the phase signal recorded by the optical sensor (11) corresponding to a synthetic wavelength, in particular by forming the difference between the at least two quantitative phase signals corresponding to the fundamental wavelength,
- a movement unit for moving an object (O) to be measured in a designated measuring range,
- an arrangement of a coupling-out unit (K) of the device (1), which directs a reference beam with a separately guided fundamental wavelength directly or deflected via an optical element onto the optical sensor (11), so that a holographic recording is achieved,
- a coupling-out unit (K) which emits two different fundamental wavelengths of different polarization, wherein the Measuring unit preferably has two optical sensors (11) and an optical unit which is designed to direct light with different polarizations in different directions,
- an imaging-optics (12) which generates an image of the object (O) which is positioned such that it is recorded by the optical sensor (11).

**Revendications**

1. Dispositif (1) pour la génération d'une longueur d'onde synthétique comprenant au moins deux émetteurs de surface (3) et un élément support (2), l'élément support (2) étant un conducteur de chaleur et l'émetteur de surface (3) étant disposé de manière fixe dans, sur ou au niveau de l'élément support (2), **caractérisé en ce que** le rapport V de la distance a entre deux émetteurs de surface (3) et la conductivité thermique effective w du matériau support V = w / a est supérieur à 5000 W/(m$^2$·K), au moins deux émetteurs de surface (3) se trouvant sur le même substrat et la distance mutuelle entre les deux émetteurs de surface (3) étant d'au moins 1 mm pour empêcher un sur-couplage de la température

2. Dispositif selon la revendication 1, **caractérisé en ce qu'**il comprend un capteur de température, un élément de régulation de température (9) et une unité de régulation de température pour réguler la température d'un émetteur de surface (3) et/ou de l'élément support (2), de préférence une résistance thermique ou un capteur à semiconducteur comme capteur de température et/ou un élément chauffant ou des éléments réfrigérants ou des éléments convenant aussi bien pour le chauffage que pour le refroidissement comme élément de régulation de température (9), le dispositif (1) présentant de préférence un élément Peltier.

3. Dispositif selon l'une quelconque des revendications précédentes, **caractérisé en ce que** l'élément support (2) est constitué essentiellement de matériaux dont la conductibilité thermique est au moins supérieure à 40 W/(m·K), en particulier supérieure à 200 W/(m·K) et contient de préférence de l'aluminium ou du cuivre, les émetteurs de surface (3) étant appliqués de préférence directement sur l'élément support (3) avec conduction électrique.

4. Dispositif selon l'une quelconque des revendications précédentes, **caractérisé en ce que** le rapport V de la distance a entre deux émetteurs de surface (3) et la conductivité thermique effective w du matériau support V = w / a est supérieur à 20000 W/(m$^2$·K), en particulier supérieur à 50000 W/(m$^2$·K), la distance des émetteurs de surface (2) étant de préférence inférieure ou égale à 1 cm, en particulier inférieure à 5 mm.

5. Dispositif selon l'une quelconque des revendications précédentes, **caractérisé en ce qu'il** présente au moins une unité d'alimentation en courant (6) réglable, qui permet une précision du réglage de courant dans la plage inférieure à μA ou inférieure à 19 μA , l'unité d'alimentation en courant (6) étant de préférence conçue de telle sorte que ses variations de courant soient inférieures à 10 μA.

6. Dispositif selon l'une quelconque des revendications précédentes, **caractérisé en ce qu'**il présente plus de deux émetteurs de surface (3), qui sont interconnectés électroniquement et optiquement de telle sorte que plus de deux longueurs d'onde de base soient émises et que deux longueurs d'onde synthétiques ou plus soient générées simultanément.

7. Dispositif selon l'une quelconque des revendications précédentes, **caractérisé en ce qu'**il comprend un système de guidage de lumière, qui est conçu pour conduire les faisceaux lumineux d'un certain nombre d'émetteurs de surface (3), et de préférence pour conduire séparément ou fusionner les faisceaux de deux émetteurs de surface (3), le système de guidage de lumière comprenant de préférence un élément du groupe composé des miroirs, diviseurs de faisceau (10), lentilles (8), éléments filtrants (7), éléments de polarisation et guides de lumière (5).

8. Dispositif selon l'une quelconque des revendications précédentes, **caractérisé en ce qu'**il comprend un certain nombre d'éléments filtrants (7) dans le parcours des rayons d'un certain nombre d'émetteurs de surface (3), le nombre d'éléments filtrants (7) étant dimensionné de telle sorte que des bandes latérales des émissions des émetteurs de surface (3) soient éliminées et que les longueurs d'onde principales soient traversées, un élément filtrant (7) étant de préférence monté du côté couplage et/ou découplage par rapport à un système de guidage de lumière.

9. Dispositif selon l'une quelconque des revendications précédentes, **caractérisé en ce qu'**au moins deux émetteurs de surface ont la même longueur d'onde prévue, de préférence au moins deux des émetteurs de surface ayant des longueurs d'onde de base qui diffèrent l'une de l'autre de moins de 10 nm, de préférence de moins de 5 nm.

10. Dispositif selon la revendication 9, **caractérisé en ce que** les longueurs d'onde de base d'au moins deux émetteurs de surface diffèrent en raison de tolérances de fabrication.

11. Dispositif selon l'une quelconque des revendications précédentes, **caractérisé en ce que** les émetteurs de surface sont positionnés de telle sorte qu'un sur-couplage de la température des zones actives de l'émetteur de surface soit évité, les émetteurs de surface comprenant de préférence des substrats et étant positionnés de telle sorte que les substrats ne soient pas en contact au niveau des zones actives.

12. Dispositif selon l'une quelconque des revendications précédentes, **caractérisé en ce qu'**au moins deux émetteurs de surface sont disposés sur un substrat, en particulier sur une plaquette.

**13.** Dispositif selon l'une quelconque des revendications précédentes, **caractérisé en ce que** le matériau de support comprend du nitrure d'aluminium et/ou de l'oxyde d'aluminium ou est constitué de ceux-ci.

**14.** Dispositif de mesure pour la mesure topographique, **caractérisé en ce qu'**il comprend un dispositif (1) selon l'une quelconque des revendications précédentes, et un capteur optique (11).

**15.** Dispositif de mesure selon la revendication 14, **caractérisé en ce qu'**il comprend un ou plusieurs des composants suivants :

- un élément optique (10, 12), de préférence un élément du groupe composé des diviseurs de faisceaux (10) miroirs, prismes et lentilles (12), grâce auquel la lumière émise par le dispositif est dirigée sur l'objet à examiner (O),
- un module d'évaluation pour déterminer le signal de phase reçu par le capteur optique (11) en fonction d'une longueur d'onde synthétique, notamment en calculant une différence entre les au moins deux signaux de phase quantitatifs en fonction de la longueur d'onde de base,
- une unité de mouvement pour permettre le mouvement d'un objet (O) à mesurer dans une plage de mesure spécifiée,
- un agencement d'une unité de découplage (K) du dispositif (1), qui dirige un faisceau de référence avec une longueur d'onde fondamentale guidée séparément directement ou déviée par l'intermédiaire d'un élément optique vers le capteur optique (11), de manière à obtenir une image holographique,
- une unité de découplage (K), qui émet deux longueurs d'onde de base différentes de polarisation différente, l'unité de mesure comportant de préférence deux capteurs optiques (11) et une unité optique, qui est conçue pour diriger la lumière avec des polarisations différentes dans des directions différentes,
- une optique d'imagerie (12) qui génère une image de l'objet (O) qui est positionnée de manière à être capturée par le capteur optique (11).

# FIG. 1

# FIG. 2

# FIG. 3

# FIG. 4

# FIG. 5

## FIG. 6

## FIG. 7

# FIG. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2589923 A1

- US 6002705 A

**In der Beschreibung aufgeführte Nicht-Patentliteratur**

- **WYANT J C**. Testing aspherics using two-wavelength holography. *Appl. Opt.*, 1971, vol. 10, 2113-8
- **S. MONTRESOR** ; **P. PICART**. Quantitative appraisal for noise reduction in digital holographic phase imaging. *Opt. Expr.*, 2016, vol. 24 (13), 14322-14343
- **R. GERCHBERG** ; **W. SAXTON**. Phase determination for image and diffraction plane pictures in the electron microscope. *Optik*, 1971, vol. 34, 275-284
- **J. FIENUP**. Reconstruction of an object from the modulus of its Fourier transform. *Optics Letters*, 1978, 327-29
- **H. FAULKNER** ; **J. RODENBURG**. Moveable aperture lensless transmission microscopy: a novel phase retrieval algorithm. *Phy. Rev. Lett.*, 2004, vol. 93 (2), 023903, 1-4
- **S. SUJA HELEN** ; **M.P. KOTHIYAL** ; **R.S. SIROHI**. Achromatic phase-shifting by a rotating polarizer. *Opt. Comm.*, 1998, vol. 154, 249